# EUROPEAN PATENT APPLICATION

(11) **EP 1 970 358 A1**
(43) Date of publication of application: **17.09.2008**
(21) Application number: 08152485.2
(22) Date of filing: 07.03.2008
(51) Int. Cl.: C04B 37/00, C04B 35/565

(54) **Chemical vapor deposited silicon carbide articles**

(30) Priority: 09.03.2007 US 905952 P
(71) Applicant: Rohm and Haas Electronic Materials LLC, Marlborough, MA 01752 (US); ACG Electronic Materials, Hillsboro, OR 97124 (US)
(72) Inventor: Lais, Kevin D., Hillsboro, OR 97123 (US); Triba, Jamie L., Nashua, NH 03063 (US); Pickering, Michael A., Dracut, MA 01826 (US)
(74) Representative: Buckley, Guy Julian

(57) **Abstract**

Chemical vapor deposited silicon carbide articles and the methods of making them are disclosed. The chemical vapor deposited silicon carbide articles are composed of multiple parts which are joined together by sintered ceramic joints. The joints strengthen and maintain tolerances at the joints of the articles. The articles may be used in semi-conductor processing.

## Description

The present invention is directed to chemical vapor deposited silicon carbide articles. More specifically, the present invention is directed to chemical vapor deposited silicon carbide articles having improved strength and dimensional tolerances.

There are many types of silicon carbide known in the ceramics industry. Each type is classified according to the process by which it is made. Each process provides a silicon carbide having one or more different physical or structural properties. Examples of the different types of silicon carbide include chemical vapor deposited silicon carbide, reaction bonded silicon carbide, sintered silicon carbide, hot pressed silicon carbide and foamed silicon carbide. While the various types of silicon carbide may have one or more overlapping properties, they are not identical, and each is readily distinguishable by X-ray diffraction analysis and chemical analysis. The different physical and structural properties of the various silicon carbides often determine their applications.

Chemical vapor deposited silicon carbide (CVD-SiC) has a combination of properties which make it highly suitable for specialized materials applications. CVD-SiC may be highly thermally conductive, chemically and oxidatively stable, heat stable, hard, scratch-resistant, electrically resistive and theoretically dense. Examples of applications where CVD-SiC is highly suitable include wafer boats used in semi-conductor processing, wafer carriers used in wet bench cleanings, furniture used in semiconductor processing chambers, optical telescope structures, optical benches and end effectors to hold semi-conductor wafers during loading and unloading from semi-conductor furnaces.

For example, processing of semiconductor wafers involves harsh conditions such as exposure to corrosive conditions, such as with corrosive compounds, such as HF, high temperatures and rapid thermal cycling. Accordingly, furnace furniture and wafer boats need to withstand such harsh conditions. One method for processing semiconductor wafers involves rapid thermal processing (RTP). Such processes are performed in rapid thermal annealing apparatus (RTA). Semiconductor wafers are treated in an RTA from room temperature to temperatures of 400° C to 1400° C in periods of time on the order of a few seconds. Such harsh conditions often result in flaws and cracks forming in the furniture and wafer boats and the sloughing off of materials from the surfaces to the furniture and boats. Damage to the furniture and boats requires replacement, and sloughing off of materials from the surfaces results in contamination of the wafers resulting in loss and increased expense.

The semiconductor industry has recognized that CVD-SiC can withstand the harsh conditions involved in semiconductor processing and is a superior material for construction of furniture and wafer boats. Prior to CVD-SiC, quartz, and later sintered silicon carbide, was used as a material for furniture and boats. However, both of these materials were, in general, inadequate to withstand the harsh processing conditions and often have to be replaced. Also, thermal incompatibility with materials used in wafer manufacture resulted in damage to the wafers causing loss and extra expense in manufacturing.

While CVD-SiC has many properties highly desirable in specialized applications, some of these same properties render it a difficult material from which to fabricate articles. For example, its hardness renders CVD-SiC difficult to machine. CVD-SiC presents substantial difficulties in fabricating articles which are too complex in shape and bulky to be practically fabricated from a single, monolithic, deposited sheet or block. CVD-SiC's high density, i.e. theoretical density, provides minimal to no porosity. Porosity facilitates parts bonding with adhesives in other types of silicon carbides, such as sintered silicon carbide.

Several techniques have been proposed to bind parts of the various types of silicon carbide. These include direct bonding, codensification of interlayers and green bodies, hot pressing of suitable silicon carbide powders, bonding with polymeric precursors, brazing and reactive metal bonding, pressurized combustion reaction, reaction with and without the use of tape and microwave joining. These techniques have limited utility for semiconductor applications due to one or more drawbacks, such as use of filler material which contaminates the furnace environment, inability of joints to withstand high service temperatures, and the need for very high temperatures or pressures during joining processing.

U.S. patent 5,683,028 to Goela et al. discloses a chemical means of securing a male/female joint between two CVD-SiC parts. The patent discloses a wafer boat composed of four monolithic CVD-SiC rods. Each rod has two male joint members that slide into corresponding female ports in respective endplates to form a single article. The joint is secured with a solid-state silicon sealant. The silicon is applied in the joint as a powder where it is heated until it melts. It is then allowed to cool and solidify to hold the parts together. The joint may be further secured with a coating of CVD-SiC.

Although the article disclosed in U.S. 5,683,028 is an improvement over many conventional wafer boats, such articles require tight dimensional tolerances at the joints during manufacture. Typically, such dimensional tolerances must be precise within +/- 0.01 mm to 0.05 mm. The more precise the tolerances required the less room there is for error in machining and mounting and handling to position the parts. Such articles are assembled using various types of fixture apparatus, which align the different parts of the article. However, some motion typically occurs between parts during the alignment process. This motion may result in some misalignment of the parts at their joints, thus increasing the tolerance range beyond +/- 0.01 to 0.05mm. This often results in defects at the joints such as gaps. Such gaps may decrease the strength of the joints, and cause parts, such as rails, to move slightly in relation to endplates where they are joined causing the boat to be tilted slightly or the endplates to be off center. This increases the magnitude of the true position (TP) of the endplates to each other, thus causing misalignment of the joints and rendering the wafer boat essentially useless for its intended purpose. This often results in the formation of cracks and breakage in the harsh conditions under which the article is used.

An increase in the TP affects the positioning of the article in semi-conductor wafer processing. For example, vertical wafer boats are positioned such that one endplate rests on a pedestal in the furnace. To achieve acceptable wafer processing the boats can not tilt in relation to the pedestal more than a few millimeters. TP values typically exceed 3 millimeters; however, TP values of 3 millimeters or less are sought, but are rarely and inconsistently achieved. Ideally the TP is 0.

Gaps also provide sites for the collection of contaminants prior to and during wafer processing. Cleaning processes often fail to remove such contaminants adequately before and after wafer processing, and ultimately result in contaminating and damaging semi-conductor wafers.

Dimensional tolerances may also be affected during application of adhesives between joints and any heating process, such as in the patent described above. Again, the strength of the joints joining the parts of the article together may be weakened resulting in flaws and cracks forming during use.

CVD-SiC is typically harder than the other types of silicon carbide. Accordingly, machining CVD-SiC parts is more difficult than machining the other types. More time and expense is required to achieve the tight tolerances desired at joints made of CVD-SiC.

Accordingly, there is a need for an improved chemical vapor deposited silicon carbide article and method of joining the parts of the article.

In one aspect an article includes at least two chemical vapor deposited silicon carbide parts joined together by sintered ceramics.

In another aspect an article includes a plurality of rods joined at opposite ends to respective endplates by sintered ceramics, the plurality of rods and the endplates are of chemical vapor deposited silicon carbide.

In an additional aspect an article includes a plurality of rods joined at one of their respective ends to a base of a backplate by sintered ceramic joints, opposite ends of the plurality of rods are joined to a support rail by sintered ceramic joints, the plurality of rods, the backplate and the support rail are of chemical vapor deposited silicon carbide.

In a further, aspect a method includes providing a paste, sol or slurry comprising one or more ceramics; applying the paste, sol, or slurry including the one or more ceramics to two chemical vapor deposited silicon carbide parts to join the parts; drying the paste, sol or slurry to form a dried composition comprising the one or more ceramics around the two chemical vapor deposited silicon carbide parts; and sintering the dried composition comprising the one or more ceramics around the two chemical vapor deposited silicon carbide parts to form a sintered ceramic joint.

In yet another aspect at least the sintered ceramics of the chemical vapor deposited silicon carbide article are coated with chemical vapor deposited silicon carbide.

The articles of chemical vapor deposited silicon carbide having parts joined together by sintered ceramics maintain tight tolerances during their assembly and prevent or reduce gap formation at the joints. The ceramics are applied as a slurry to the joints and form a seal around the joint parts preventing the gap formation. This prevents or reduces particle contamination of semi-conductor wafers during processing, reduces the difficulty in cleaning the articles, and increases the strength of the joints reducing the formation of flaws and cracks. Additionally, the TP of the articles are reduced at least at their most critical alignment position in contrast to many conventional articles composed of silicon carbide. Accordingly, mating parts do not have to be machined to tight tolerances.
Figure 1 is a perspective view of a chemical vapor deposited silicon carbide wafer boat with rails secured to endplates by sintered ceramics;
Figure 2 is a view of an endplate and rails secured to the endplate by sintered ceramics of a chemical vapor deposited silicon carbide wafer boat showing the teeth and grooves of the rails;
Figure 3 illustrates a front view of a joint with a fillet radius;
Figure 4 illustrates an open joint with a rectangular rod inserted into a port of an endplate;
Figure 5 illustrates an open joint with a rod having a fissure at its base and an endplate which has three faces on each of its sides;
Figure 6 illustrates another open joint with a rod having a wedge fissure and an endplate which has three faces on each of its sides;
Figure 7 is a cross section of a closed joint showing the ceramic binder and a coat of CVD-SiC;
Figure 8 Illustrates a front view of another embodiment of a closed joint and the location of the ceramic binder in the joint; and
Figure 9 is a perspective view of a lifter for holding semiconductor wafers.

As used throughout this specification, the following abbreviations have the following meaning unless the context indicates otherwise: °C = degrees Celsius; mm = millimeters; cm = centimeters; 2.54 cm = 1 inch; slpm = standard liters per minute; torr = pressure required to support 1 mm of mercury at 0° C; 1 mm of mercury = 0.00132 atmospheres (atm); 1 atm = 1.01325x10⁶ dynes/cm²; µm = micron; ppb = parts per billion; CVD = chemical vapor deposited; SiC = silicon carbide; RMS = root mean squared; OD = outer diameter; and TP = true position.

The term "true position" is defined as the perfect (exact) location of a point, line or plane (normally the center) of a feature in relationship to a datum reference feature. The term "monolithic" means a single solid piece of a material having a theoretical density of at least 98%. The term "joint" means an area at which at least two ends, surfaces or edges are attached. The term "joining" means to unify a plurality of parts.

All numerical ranges are inclusive and combinable in any order except where it is logical that such numerical ranges are constrained to add up to 100%.

Articles include at least two CVD-SiC parts joined together by sintered ceramics. Joints formed between CVD-SiC parts and sintered ceramics provide joints which are stronger than many conventional joints for articles made of silicon carbide, including CVD-SiC. Such joints can withstand the harsh conditions of semiconductor wafer processing, and have TPs of 3 mm or less. Additionally, the CVD-SiC and sintered ceramic joints enable assembly of the articles with increased dimensional tolerances without the formation of gaps in the joints, thus reducing the probability of damage to the articles under harsh semiconductor processing conditions.

Suitable CVD-SiC includes any CVD-SiCs known in the art. Typically, such CVD-SiC is high purity CVD-SiC with a total amount of metal impurities of 50 ppb, or such as 30 ppb or such as 10 ppb. Such CVD-SiC materials include, but are not limited to, β-crystalline CVD-SiC, α-CVD- SiC as well as CVD-SiC having mixtures of α and β- CVD SiC. This includes, but is not limited to, cubic β-CVD-SiC as well as β-CVD-SiC having cubic and hexagonal crystalline structures. Such CVD-SiC may be made by any suitable method known in the art and disclosed in the literature. Typically, the CVD-SiC is formed as a monolithic part. Such CVD-SiCs may have a theoretical density of at least 90%.

Typically the CVD-SiC used to make the parts of the articles is cubic β-crystalline SiC. Examples of methods of making cubic β-crystalline CVD-SiC are disclosed in U.S. 5,374,412 and U.S. 5,354,580. Gaseous reactants are deposited on a substrate, such as a mandrel, in a CVD furnace to form a monolithic cubic β-crystalline CVD-SiC part. Such methods provide cubic β-crystalline CVD-SiC which is pure cubic β-crystalline CVD-SiC as shown by X-ray diffraction analysis. No hexagonal crystalline structures are observable on an X-ray diffraction spectrum of such cubic β-crystalline CVD-SiC. Such cubic β-crystalline CVD-SiC has a theoretical density of at least 98%. Typically, the theoretical density is from 98% to 99%.

The CVD-SiC parts may be machined to provide a desired shape and roughness. Conventional machining may be used. Such methods are well know in the art and may be obtained by methods disclosed in the literature. Because higher dimensional tolerances are acceptable for the articles made by joining CVD-SiC parts together with sintered ceramic materials than conventional methods, less machining is done to match joining parts. This is highly desirable since CVD-SiC is a hard and difficult material to machine precisely. Typically, sections of the parts which make-up the joint are the least machined. Roughness and any protrusions from the surfaces of the joint sections are coated with sintered ceramics. Also, the roughness and protrusions increase surface area to further strengthen the joint. Average surface roughness Rₐ is from 0.2µm to 5 µm. Rₘₐₓ may range from 2 µm to 50µm.

Any method for measuring surface roughness may be used. One suitable method is an autocovariance function. For a description of the application of an autocovariance function to the determination of surface topography, see Kiely et al., Quantification of Topographic Structure by Scanning Probe Microscopy, Journal of Vacuum Sceince Technology B, vol. 15, no. 4, July/August 1997, pp 1483-1493. Further descriptions of roughness parameters and methods of determining the values of these parameters are provided in Standard ASME B46.1-2002, *Surface texture (Surface Roughness, Wavines and Lay),* American Society of Mechanical Engineers, 2003. Typically, the directionality surface topography of the surface features are determined using atomic force spectroscopy (AFM) or an optical profilometer.

The methods may be used to join two or more CVD-SiC articles of various sizes and shapes. Such shapes include, but are not limited to, columnar shape, rod shaped, cylindrical shaped, plate shaped, sheet shaped, film shaped, square rod shaped, flat plate shaped, conical shaped, frustaconical shaped, pyramid shaped and rhomboid shaped. Joining may be carried out not only between parts of the same shape, but also between parts having different shapes.

Ceramic materials which may be used to form the joints of the articles include ceramics which enable the desired joint strength and dimensional tolerances. Such ceramic materials include, but are not limited to, silicon carbides, silicon nitride, various oxides and mixtures of the various oxides, including mixtures of the oxides with silicon carbide. Such oxides include, but are not limited to, oxides of aluminum, nickel, lanthanum, barium, zinc, lithium, cobalt, cadmium, cerium, chrome, antimony, iron, yttrium, tantalum, tungsten, strontium, calcium, bismuth, tin, manganese, magnesium, zirconium, titanium, lead, niobium and silicon.

Other suitable ceramics include, but are not limited to, raw mineral materials. Such raw mineral materials include, bur are not limited to, shale, stoneware, clay, bauxite, kyanite, bentonite, kaolin, pyrophilite, talc, feldspar, nepheline syenite, wollastonite, spodumene, flint (quartz), zircon, zirconates and corderite. Mixtures of such raw mineral materials may be used. The raw minerals may be mixed with one or more of the ceramic oxides, silicon nitride and silicon carbide.

The ceramics are applied to the joint in the form of a paste, sol or slurry. Conventional pastes, sols and slurries may be used as well as conventional methods of making them. The ceramics are included in conventional amounts. Typically, the ceramics are included in amounts of 20wt% to 80wt% of the composition.

In addition to one or more ceramics, pastes, sols and slurries include mixtures of such components as one or more binders, vehicles, plasticizers, dispersants, sintering aids and various conventional processing aids well known in the art. The amounts of each of the components are conventional and vary depending on whether it is a paste, sol or slurry. Amounts are well known to those of skill in the art.

Typically the binders are organic. Such organic binders include, but are not limited to, waxes, thermosetting resins, gums, polyvinyl alcohols, polyvinyl acetate, celluloses, polycarbosilanes, polyethylene glycols, thermoplastic resins and mixtures thereof. Typically, such binders are one or more of methyl cellulose, polyvinyl acetate, acrylic resins and dextrin. Binders may range in amounts of 0.5wt% to 50wt%.

Dispersing agents are used to distribute and suspend the ceramic materials. Such dispersing agents include, but are not limited to, polyacrylic acid, acrylic/maleic acid copolymer, lauryl sulfate, dodecylbenzenesulfonate, pyrophosphate and water-soluble salts, such as ammonium and alkali salts. Typically dispersing agents are used in amounts of 0.5wt% to 10wt%

Plasticizers include both water-soluble and water-insoluble plasticizers. Such plasticizers include, but are not limited to, water, ethylene glycols, polyethylene glycols, glycerol, dibutyl phthalate, dimethyl phthalate and mixtures thereof. Typically, plasticizers are included in amounts of 1wt% to 15wt%.

Sintering aids typically include many of the organic compounds used as binders as well as other conventional organic sintering aids. Other sintering aids include, but are not limited to, inorganic compounds, such as boron carbide, Mg₃N₂, AlN and various oxides, such as MgO, CeO₂, ZrO₂, BeO, Y₂O₃ and La₂O₃. Typically, sintering aids are included in amounts of0.5wt% to 10wt%.

Vehicles include water, organic solvents and mixtures thereof. Such organic solvents include, but are not limited to, dimethyl formamide, methoxyethanol, acetic acid, alcohols and glycols. Typically, the vehicles are aqueous. Sufficient amount of vehicle is added to the compositions to bring them to a desired volume and viscosity.

The components may be mixed using conventional apparatus. Mixing the components may be done at room temperature or may be heated to a sufficient temperature to uniformly disperse the components in the mixture and increase the ease of mixing the various components. The ceramic materials are used in powder or granular form and may be of any particle size which enables the formation of a uniform or homogeneous dispersion. Particle sizes are conventional. Typically, particle sizes range from 0.05µm to 1000µm, or such as from 10µm to 500µm or such as from 25µm to 250µm. As with the other components described above many of the particles are commercially available or may be made according to methods disclosed in the literature.

The paste, sol or slurry may be applied by any suitable means known in the art. Typically, they are applied to spaces between the parts which make-up the joint as well as covering the joint portions of the parts. The ceramic is applied with any suitable tool such as a brush or spatula. The ceramic is applied such that a smooth surface is formed without any gaps in spaces between the parts and covers any protruding parts. Any gaps may be coated with additional ceramic material and smoothed over. Such gaps may cause weak points in the joint resulting in misalignment of the article parts during handling and use. Two or more CVD-SiC parts may be joined with the ceramic paste, sol or slurry. If any of the parts of the joint do not match up, they may be covered with the ceramic material. Accordingly, the parts need not contact each other as in contrast to conventional articles which require tight tolerances. Accordingly, tight dimensional tolerances are not needed.

After the ceramic is applied it is dried at room temperature to form a dried composition. It is then sanded down to a smooth transition. Sanding may be done by any conventional method. Conventional grade sand paper may be used or any power sanding tool. Diamond tools having various grits may be used.

Conventional fixtures may be used to retain and align the two or more parts while the ceramic is applied. The parts are retained and aligned such that the TP for the most critical alignment is maintained at 3 mm or less, i.e. greater than 0, after sintering the joints. Typically, the TP for the most critical alignment is from 1.5 mm to 2 mm with a dimensional tolerance of +/- 0.5 to 1 mm. For vertical wafer boats the most critical alignment is the TP of the top endplate and rails to the bottom endplate. For other articles, such as wet bench wafer carriers or lifters the critical dimensions are the perpendicularity of the rods to the backplate and the parallelism of the rods to each other. Any conventional method may be used to measure the TP of an article. Methods include, but are not limited to, coordinate measuring machines (CMM), FaroArm™ instrument, which is obtainable from Faro Technologies, Inc., laser tracker or other conventional 3-D measurement techniques.

Sintering may be done by any suitable method known in the art. Conventional methods may be used. In general, after the ceramic is applied to the joints, the article still fastened to the fixture is placed in a sintering furnace. The furnace is heated to a temperature of 1500° C to 2100° C. Sintering is done for 30 minutes to 24 hours. Sintering drives off any moisture in the paste, sol or slurry containing the ceramic and carbonizes any organic binders and other organic material to solidify the joint. Additional examples of sintering methods which may be used to form the joint include, but are not limited, to those methods disclosed in U.S. 4,351,787, U.S. 6,065,615, Datta et al., Sintering of nano crystalline α silicon carbide by doping with boron carbide, Bull. Mater. Sci., Vol. 25, No. 3, June 2002, pp 181-189 and Zhou et al., Thermal conductivity of silicon carbide densified with rare-earth oxide additives, Journal of the European Ceramic Society 24 (2004) 265-270.

The sintered ceramic joint binding the two or more CVD-SiC parts has improved strength and stability over many conventional SiC joints whether from CVD-SiC or of the other types of SiC known in the art. The TP of the articles is maintained within a more narrow acceptable range than the TP of many conventional articles. Accordingly, the probability of large alignment error is reduced. This prevents gaps from forming in the joints, which weakens the joints, and reduces the probability of damage to the articles during handling and use under harsh conditions. Further, because the TP ranges are maintained from 3 mm or less, the difficulty of maintaining precise dimensional tolerances of+/- 0.01 to 0.05 mm during manufacture is avoided.

Optionally, a coating of CVD-SiC may be deposited on at least the joints, but the entire article may be coated with a layer of CVD-SiC. The coating may have a thickness range of 0.5 mm to 3 mm. Typically, the thickness of the CVD-SiC coating may range from 1 mm to 2 mm. The CVD-SiC coating may be applied by any suitable method of depositing CVD-SiC known in the art. Examples of such methods are disclosed in U.S. 5,354,580 and U.S. 5,374,412.

Minor machining may be used to smooth and remove any undesired rough parts on the surface of the article after application of the CVD-SiC coating. Such minor machining does not alter the TP of the article significantly. Minor corrections may be needed to true up the article to provide the desired TP.

The types of articles which may be made by the methods include, but are not limited to, wafer boats, wafer carriers used in wet bench cleaning, furniture used in semiconductor processing chambers, optical telescope structures, optical benches and end effectors to hold wafers during loading and unloading.

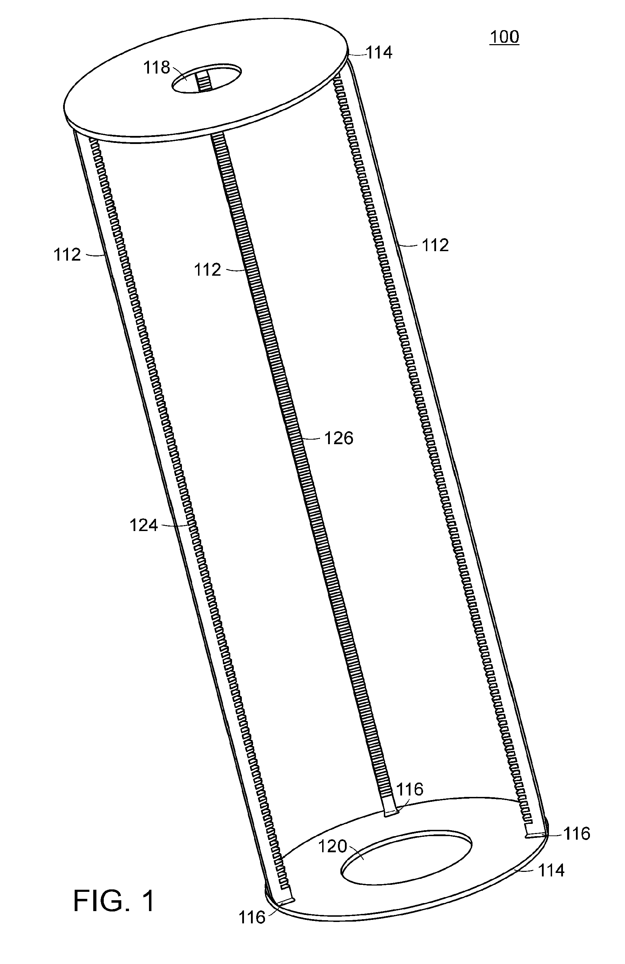

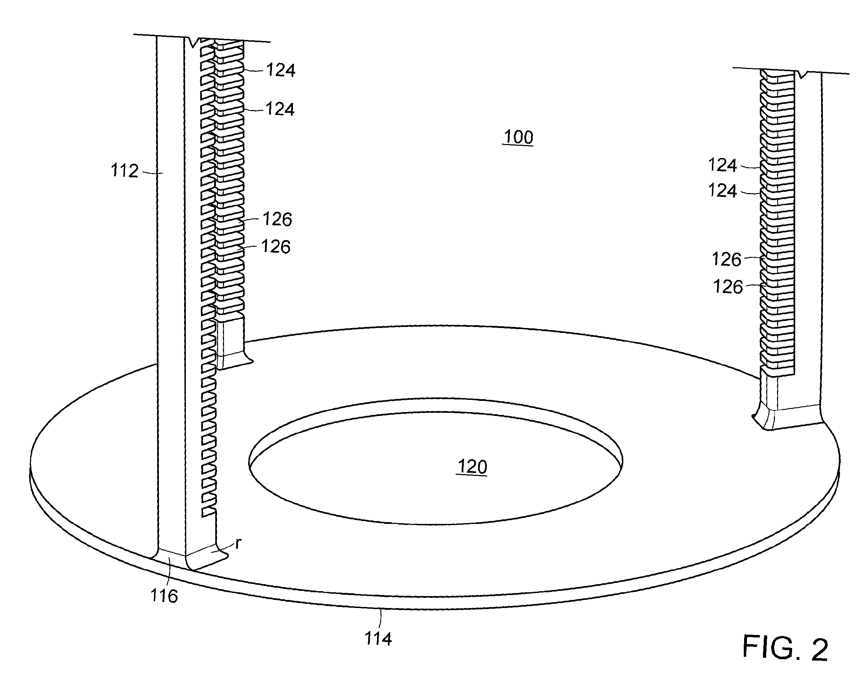

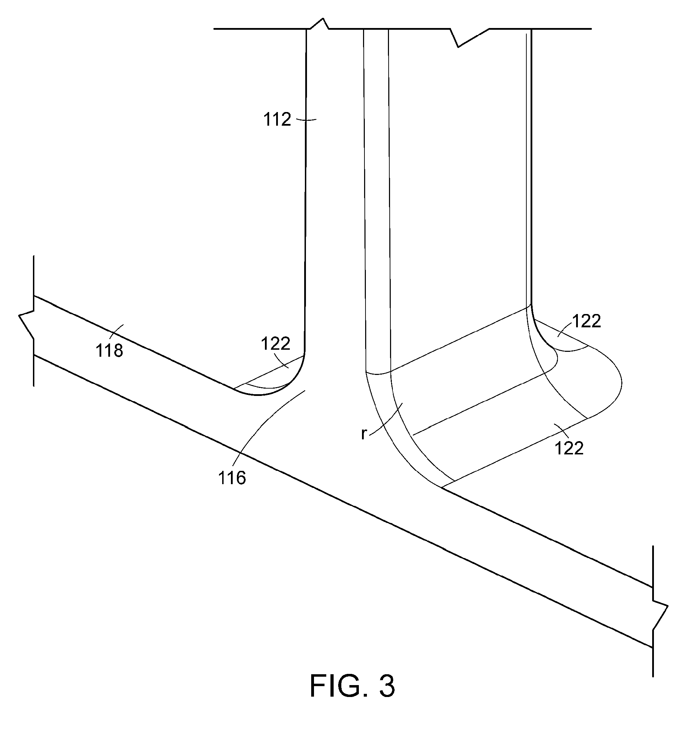

Figures 1, 2 and 3 illustrate one embodiment of a wafer boat composed of monolithic CVD-SiC parts for holding a plurality of semiconductor wafers for semiconductor wafer processing. Wafer boat **100** includes a plurality of rods **112** inserted into ports at the sides of endplates **114.** The rods **112** are secured to the endplates **114** by sintered ceramic joints **116.** The sintered ceramic joints **116** as shown in Figures 1, 2 and 3 are closed joints. The endplates include holes **118** and **120** at their center for the passage of gases during semiconductor wafer processing. The sintered ceramic joints **116** form a concave fillet radius **r** at the junction of the plates and the rods. The fillet radius **r** has three faces **122.** The sintered ceramic joints **116** have a 2 mm coating of CVD-SiC. The rods **112** include a plurality of teeth **124** with alternating grooves **126** for retaining semiconductor wafers.

Figures 1, 2 and 3 disclose one embodiment of the wafer boats. The wafer boats are not limited to the embodiment disclosed in the Figures. The number and the dimensions of the teeth and grooves may vary. Conventional machining techniques may be used to vary the number and dimensions of the teeth and grooves. Also, the holes are optional, and the number of rods may vary from 2 to 4. The wafer boats may have a joint which does not form a fillet radius at the junction of the rods and plates.

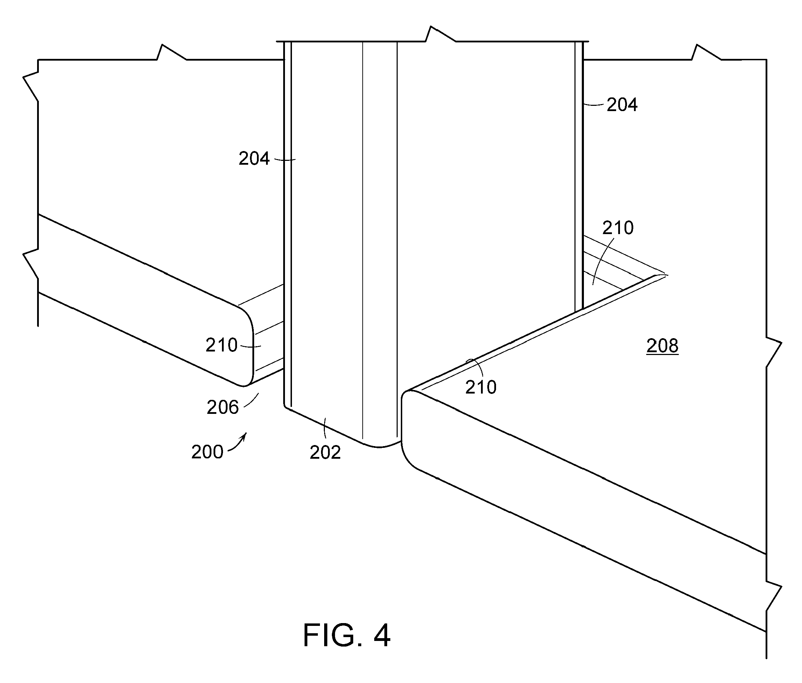

Figure 4 illustrates one embodiment of an open joint of a wafer boat. The open joint **200** includes a rectangular rod **202** with four faces **204** of which only two are shown in the Figure. Rod **202** is inserted in port **206** of plate **208** such that it does not contact any of the three sides **210** of the port. The portion of the rod which is within the port has Ra of 0.05µm to 0.5µm. When the joint is completed, the open joint **200** is sealed with sintered ceramic material (not shown). The joint may be coated with CVD-SiC to provide further strength and durability to the joint.

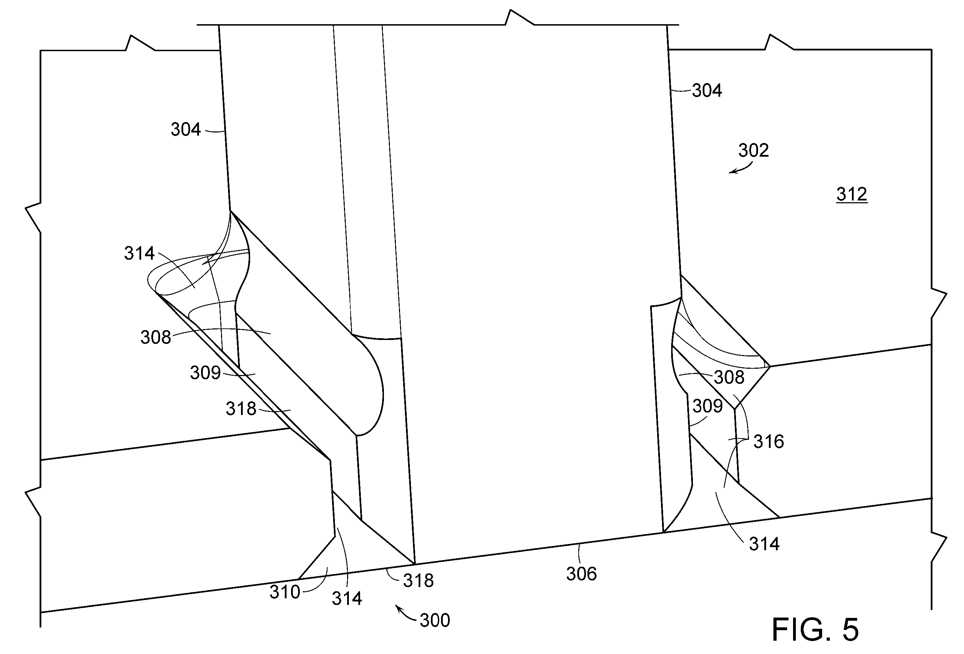

Figure 5 illustrates another embodiment of an open joint of a wafer boat. The open joint **300** includes a rectangular rod **302** with four faces **304** of which only two are shown in the Figure. The rectangular rod **302** has a base **306.** The base **306** includes two concave fissures **308** on two opposing sides of the base. The concave fissures **308** extend along the length of the base and are perpendicular to the length of the rectangular rod. Each fissure **308** terminates at a flat surface **309** at a bottom portion of the base **306** of the rectangular rod. The rectangular rod is inserted into the port **310** at a side of endplate **312.** The rectangular rod **302** is inserted into the port such that it does not touch the three sides **314** of the port **310.** Each of the three sides **314** has three contiguous faces **316.** The concave fissures and the three faces of the sides of the port increase the surface area of the joint, thus increasing the strength of the joint after the port is filled with sintered ceramic material to form the completed closed joint. Imaginary lines **318** illustrate where the ceramic material fills in the open joint **300.** Optionally, the portions of the rectangular rod and sides of the port which are included in the joint may have a surface roughness of Rₐ from 0.05µm to 0.5µm.

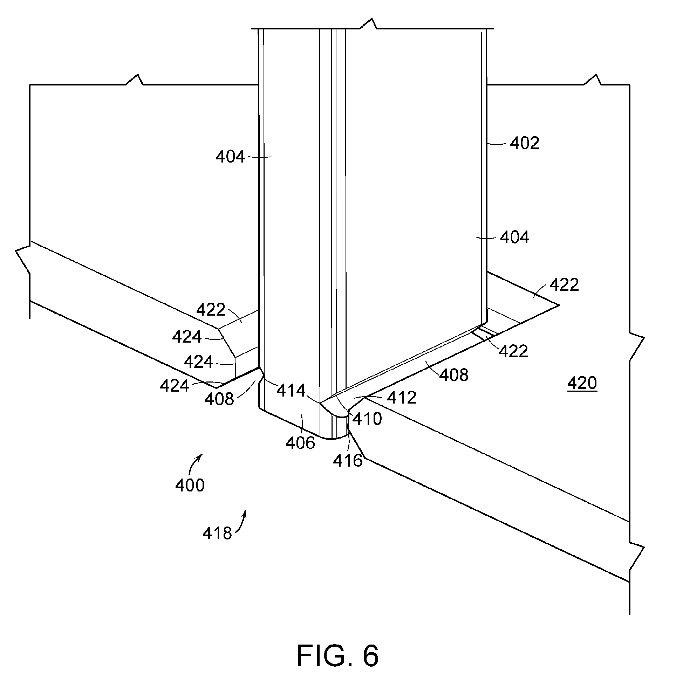

Figure 6 illustrates a further embodiment of an open joint of a wafer boat. Open joint **400** includes a rectangular rod **402** with four faces **404.** Base **406** of rectangular rod **402** includes two wedge fissures **408** on opposite sides of the rectangular rod **402.** Each wedge fissure **408** extends the length of the base **406** and is perpendicular to the length of the rectangular rod **402.** Each wedge fissure includes two opposing faces, a top face **410** and a bottom face **412.** Each face is joined at a common junction **414** opposite an opening of the wedge fissures. Each bottom fissure **412** terminates at a respective face **416** on each side of a bottom of base **406.** The rectangular rod is inserted into port **418** of endplate **420** such that it does not contact any of the three sides **422** of the port of the endplate. Each side **422** has three contiguous faces **424.** The open joint is filled with a paste, sol or slurry of ceramic material, dried and then sintered to secure the joint components. The wedge fissures and the faces of the sides which define the port increase the surface area where the ceramic material is applied to increase the strength of the joint. Optionally, the parts which compose the joint may be machined to have a roughness of 0.05µm to 0.5µm, which further strengthens the joint. The joint may be coated with CVD-SiC.

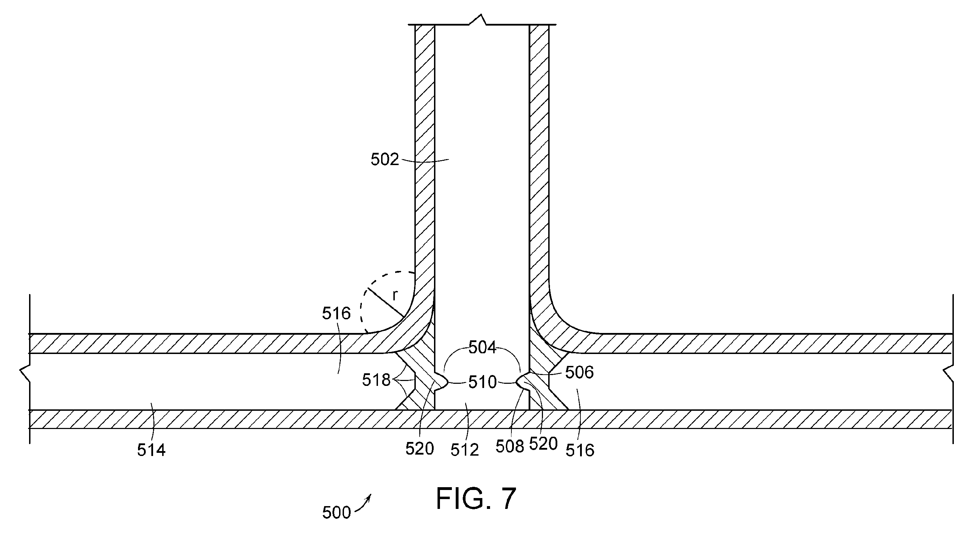

Figure 7 is a cross section of a closed joint. The closed joint **500** includes a round rod **502** with a wedge fissure **504** having three faces, a top face **506,** bottom face **508** and side face **510** where the top and bottom faces meet, the wedge fissure circumvallates the rod. The wedge fissure separates the main portion of the rod from its base **512.** The round rod **502** is inserted in a port at a side of endplate **514.** The rod does not contact the sides of the port. The port is defined by its three sides **516,** two of which are shown in Figure 7. Each side has three contiguous faces **518.** The space between the rod and the sides of the port are filled with sintered ceramics **520.** The entire joint as well as the rod and endplate are coated with a layer of CVD-SiC **322.** A fillet radius **r** is formed at the junction of the rod and the endplate. Optionally, the portions of the rod which are included in the joint and the faces of the port may be machined to provide a roughness Rₐ of 0.05µm to 0.5µm.

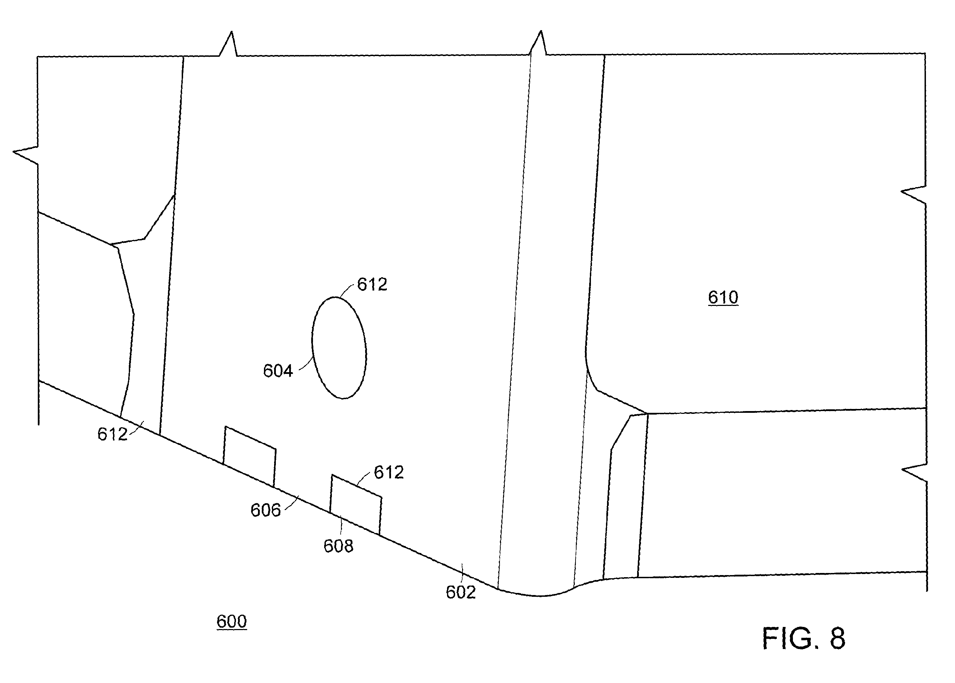

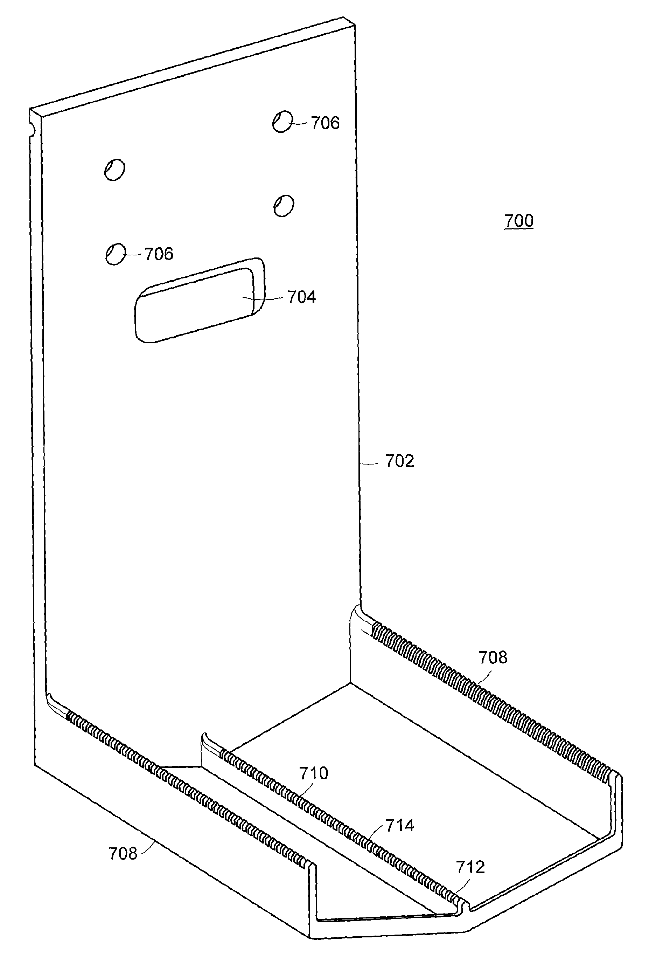

Figure 8 illustrates a further embodiment of a closed joint. This type of joint is found in the wet bench carrier or lifter as shown in Figure 9. Closed joint **600** includes flat rod **602,** which includes a port **604** near a base **606** of the flat rod **602** and two rectangular fissures **608** at the base **606** of the flat rod **602.** The flat rod **602** is inserted into a backplate **610** in a backplate port which is filled with sintered ceramic **612** along with port **604** and rectangular fissures **608.** Optionally, the parts composing the joint may be roughened to a desired surface roughness Rₐ, and coated with CVD-SiC.

Figure 9 illustrates a wet bench carrier or lifter **700** for supporting semiconductor wafers during semiconductor wafer processing. Backplate **702** includes tooling holes **704** and **706** at an upper end of the backplate **702** for mounting the lifter on a mechanism which moves the lifter in and out of chemical solutions during wafer processing. Rods **708** and **710** are joined at one end to a base of the backplate **702** by sintered ceramic joints as shown in Figure 8. Rods **708** and **710** include a plurality of alternating teeth **712** and gaps **714** for supporting semiconductor wafers (not shown). The rods are secured at ends opposite the backplate by a support rail **716,** which is perpendicular to the length of the rods. The rail is joined to the rods by ceramic joints.

While the articles and joints have been described with typical embodiments, the articles and joint parts are not limited to the shapes described above, but are envisioned to include articles having parts of varying geometry. For example, endplates may not only be elliptical in shape, but polygonal such as rectangular and triangular. Rods may not only have two or four faces or rounded, but may have two or three or more faces. The rods, in general, are polygonal. Further, surfaces of the base of the rods and sides of the endplates which define the port are envisioned to include any protrusion which increases the surface area and further secures the joint when filled with sintered ceramic material.

The most critical alignment issue for wafer boats as described in Figures 1-7 is the TP of the endplates to each other. With respect to lifters, as described in Figures 8 and 9, the critical dimensions are the perpendicularity of the rods to the backplate and the parallelism of the rods to each other. Typically the TP is 2 mm or less with a dimensional tolerance of +/- 0.5 to 1 mm. For example, when the wafer boat is a vertical boat, the TP is determined by measuring the position of the top endplate relative to the center line created by the bottom endplate using a FaroArm™ instrument. The instrument permits touching the boat at different locations and the different locations in space are calculated relative to a stationary point in space (reference point). The OD of the bottom plate and the bottom plate surface are measured to determine the center which runs through the center of the bottom plate and perpendicular to the bottom plate surface. The top plate OD is then measured and its center position relative to this center line is determined. The TP is then calculated by multiplying the distance by which the top plate is displaced from the center line by 2. Horizontal boats are measured by the same procedure as vertical boats. The horizontal boats are placed in a vertical position and the TP is determined by measuring the position of the top endplate relative to the center line created by the bottom endplate using a FaroArm™ instrument.

The following examples further illustrate the invention and are not intended to limit the scope of the invention.

### Example 1 (comparative)

Three types of joints were prepared to test their strength using a standard test method for testing the strength ofjoints. Two of the joint types included circular CVD-SiC endplates with corresponding rectangular CVD-SiC rods for insertion into the side ports of each endplate. The third type of joint was composed of circular sintered silicon carbide endplates and corresponding rectangular sintered silicon carbide rods for insertion into the side ports of the endplates. The CVD-SiC endplates and rods were made from a conventional CVD-SiC method and obtained from Rohm and Haas Company from its Advanced Materials business in Woburn, MA, U.S.A. The sintered silicon carbide endplates and rods were made by a conventional sintering method with silicon impregnated in the sintered silicon carbide.

The first joint type was formed by inserting CVD-SiC rods into the ports of the CVD-SiC endplates to form a conventional male/female type joint. The tolerances were chosen such that a side gap between the rod and the port fell in the range of 0.01 to 0.05 mm. This gap was appropriate for capillary action to push molten silicon into the side gap.

Silicon powder was used to bind the joint components. The powder was purchased from Johnson Matthey (Asear). A small amount of the silicon powder was placed at the bottom of the plate in the port and the rod was inserted into the port. The assemblies were placed in one deposition box of a four-box production run. Conventional fixtures held the part together. The samples were heated to a temperature of 1360° C in an argon atmosphere. Silicon carbide was deposited on the joints by passing a mixture of methyltrichlorosilane (MTS), hydrogen gas and argon through the deposition area. Deposition parameters were as shown in Table 1 below. Silicon carbide deposition continued until a coating of 2 mm was formed on the joints.

**Table 1**

| **PROCESS PARAMETERS** | **AMOUNT** |
|---|---|
| Furnace Pressure | 200 torr |
| Deposition Temperature | 1360° C |
| H₂ gas flow rate | 124 slpm |
| Ar gas flow rate | 408 slpm |
| MTS gas flow rate | 24.5 slpm |
| H₂ gas partial pressure | 44 torr |
| Ar gas partial pressure | 147 torr |
| MTS partial pressure | 9 torr |
| Deposition Rate | 0.08 mm/hour |
| H₂/MTS gas flow ratio | 5 |

After deposition of the silicon carbide was completed, the deposition chamber temperature was increased to 1485° C to bring the silicon to its molten state. The joints were maintained at 1485° C for 0.5 hours. The deposition chamber was then allowed to cool down and the joints were removed from the chamber. All of the joints were then visually inspected for cracks. None of the joints showed any visible cracks or flaws. The joints were machined using 220 grit diamond impregnated grinding wheels and tools to form joints roughened to 0.5µm RMS.

The second set of joints was prepared from slurries by mixing 75wt% silicon carbide powder, 7wt% methyl cellulose as a binder and 18wt% water. The slurries were shaped in a gypsum mold by slip casting and then the shaped slurry was cut to obtain end palates and bars in a green body. An adhesive which was made from the same slurry used to prepare the joint parts was applied at the junction of the rods and the ports of the endplates. Assembly of the joints was done using a conventional fixture. Dimensional tolerances during assembly were maintained from 0.01 to 0.05 mm. The joints in their fixtures were than placed in a sintering furnace and fired for 60 minutes at 1800° C to obtain sintered silicon carbide joints.

After sintering was completed the furnace was allowed to cool and the joints were removed and inspected. No flaws or cracks were visible. The joints were than machined using 220 grit diamond impregnated grinding wheel to form joints roughened to 0.5µm RMS.

The third set of joints was formed by inserting CVD-SiC rods into ports of CVD-SiC endplates. The base of the rods and the sides of the ports were machined using 220 diamond impregnated grinding wheels such that the Rₐ was from 0.1 to 0.5µm. The parts were aligned using a fixture such that the dimensional tolerances were from 0.1 to 0.5 mm. A silicon carbide slurry composed of 75wt% silicon carbide, 7wt% methyl cellulose and 18wt% water was applied to the joints with a spatula. Excess was applied to the joints to fill in the spaces between the joint components and cover the portions of the rods and endplates which composed the joints. The slurry was smoothed around the joints to form a fillet radius. The slurry was allowed to dry at room temperature, and the dry composition was then sanded down to provide a smooth transition at the joints.

The joints, still in their fixtures, were placed in the sintering furnace. Sintering was done at 2000° C for 24 hours. The furnace was then allowed to cool and the joints were removed from the furnace. No cracks or flaws were observed in the joints.

Graphoil^{™} masks (thin sheets of graphite) were then placed over the rods and endplates except at the joints, which remained exposed. The joints were then placed in the deposition chamber and coated with 2 mm of CVD-SiC. The deposition conditions and reactants were as disclosed in Table 1 above. After the chambered cooled the joints were removed and the CVD-SiC coatings on the joints were machined to an RMS of 0.5µm using the 220 grit diamond wheel.

Each of the three types of joints was then placed in a standard Instron Mechanical Tester^{™} to test the amount of load the joints could tolerate before breaking. The endplate of each joint was secured into a fixture to hold the endplate with the rod protruding from the fixture horizontally such that the distance from the endplate to the point on the rod where the load (force) was applied was 2.5 inches (6.3 cm). The Instron Mechanical Tester^{™} head (load cell) was then set to move at a speed of 0.02 inches/minute (0.05 cm/minute) pushing down on the rod section. The load value in pounds and load rate (inches per minute) were recorded on a conventional chart recorder and the point at which the joint fractured was identified on the chart recorder and used to determine the load (force) on the rod that caused it to fracture.

The results showed that on the average the CVD-SiC coated joints with the parts joined by sintered silicon carbide were 35% stronger than the CVD-SiC coated joints with the molten silicon joints, and over 20% stronger than the joints composed entirely of sintered silicon carbide. Accordingly, the CVD-SiC coated joints with the CVD-SiC parts joined by sintered silicon carbide had improved strength over the conventional joints.

### Example 2 (comparative)

Three types of wafer boats distinguished by the types of joints which joined their parts were prepared from CVD-SiC to compare their TPs. The CVD-SiC parts were prepared by depositing silicon carbide on graphite mandrels having the appropriate shapes and sizes in a chemical vapor deposition furnace. The reaction components and parameters which were used were as disclosed in Table 2 below.

**Table 2**

| **PROCESS PARAMETERS** | **AMOUNT** |
|---|---|
| Furnace Pressure | 200 torr |
| Deposition Temperature | 1360° C |
| H₂ gas flow rate | 124 slpm |
| Ar gas flow rate | 408 slpm |
| MTS gas flow rate | 24.5 slpm |
| H₂ gas partial pressure | 44 torr |
| Ar gas partial pressure | 147 torr |
| MTS partial pressure | 9 torr |
| Deposition Rate | 0.08 mm/hour |
| H₂/MTS gas flow ratio | 5 |

After the parts were formed on the mandrels, they were removed and machined using 220 grit diamond tools to remove any undesired rough surfaces formed during deposition and to shape the parts. The parts were then assembled to form three wafer boats each having a different type of joint assembly. Each boat included three rectangular rods joined at their opposite ends by endplates. All the boats were assembled in conventional fixtures to properly align their parts to desired dimensional tolerances.

The first type of boat had wedge joints to hold the rods to the endplates. Each rod was beveled at their ends and inserted in rectangular ports in the endplates. CVD-SiC wedges, which complement the beveled ends of the rods, are inserted on the opposite sides of the endplates to secure the rods in the endplates. After assembly small gaps were observed between the rods and the endplates at all of the joints

The second type of boat had rod ends which were inserted into complementary ports which opened at the side of the endplates. The rods were secured to the endplates by a CVD-SiC pin which was inserted into bores in the rods perpendicular to the lengths of the rods. Complimentary bores in the endplates enable the pins to pass through the bores in the rods and then into the endplates themselves to secure the rods to the endplates. After assembly small gaps were observed between the rods and the endplates at all of the joints.

The third type of boat had rod ends which were placed into side ports of endplates which were not complimentary to each other. The parts did not fit together such that the rods touched the sides of the ports as in the other two types of joints. There was open space between the rods and the sides of the endplates. The parts were secured in the joints by applying an excess of a slurry of 75wt% silicon carbide powder, 7wt% methyl cellulose and 18wt% water. The entire joint was coated with the slurry and then smoothed to form a fillet radius around the joint. The slurry was allowed to dry at room temperature and then sanded down to make a smooth transition surface. The boat was then placed in its fixture in a sintering furnace and fired at 2000° C for 24 hours. After the furnace cooled the boat was removed. No flaws, cracks or gaps were observed around any of the joints secured by sintered silicon carbide.

The TP of the endplates to each other of all three types of boats was determined using the conventional FaroArm^{™} 3-D measurement technique. In the measuring process each boat was treated as a vertical type wafer boat. The position of the top endplate was measured relative to the center line created by the bottom endplate. The OD of the bottom endplate and the bottom endplate surface were measured to determine the center which runs through the center of the bottom endplate and perpendicular to the bottom endplate surface. The top endplate OD was then determined and its center position relative to this center line was determined. The TP of the wedge joint boat was determined to be 5.10 mm, the TP of the boat with the pinned joint was 3.06 mm, and the TP of the boat with the sintered joint was 2.27 mm. The results showed that the sintered joint was 35% better than the pinned joint and 125% better than the wedge joint.

Further, no cracks, flaws or gaps were observed in the sintered joint as in the wedge joint and the pinned joint. The gaps observed in the joints of the wedge joint and the pinned joint enable the rods to move in relation to the endplates causing the boats to tilt or causing the endplates to be on different center lines. This in turn undesirably increases the TP of the boats as shown in the results above. Also, the gaps can cause misalignment during mounting, handling and heat up due to expansion of the rods and endplates. In contrast the boat with the sintered joint had no gaps. Accordingly, the TP is better and the probability of misalignment is reduced.

## Claims

1. An article comprising at least two chemical vapor deposited silicon carbide parts joined together by sintered ceramics.

2. The article of claim 1, wherein at least the sintered ceramics are coated with chemical vapor deposited silicon carbide.

3. The article of claim 2, wherein the chemical vapor deposited silicon carbide coat is 0.5 to 3 mm thick.

4. An article comprising a plurality of rods joined at opposite ends to respective endplates by sintered ceramics, the plurality of rods and the endplates are of chemical vapor deposited silicon carbide.

5. The article of claim 4, wherein at least the sintered ceramics are coated with chemical vapor deposited silicon carbide.

6. The article of claim 4, wherein the true position of the endplates to each other is 2 mm or less.

7. An article comprising a plurality of rods joined at one of their respective ends to a base of a backplate by sintered ceramic joints, opposite ends of the plurality of rods are joined to a support rail by sintered ceramic joints, the plurality of rods, the backplate and the support rail are of chemical vapor deposited silicon carbide.

8. A method comprising:
a) providing a paste, sol or slurry comprising one or more ceramics;
b) applying the paste, sol or slurry comprising the one or more ceramics to two chemical vapor deposited silicon carbide parts to join the parts;
c) drying the paste, sol or slurry to form a dried composition comprising the one or more ceramics around the two chemical vapor deposited silicon carbide parts; and
d) sintering the dried composition comprising the one or more ceramics around the two chemical vapor deposited silicon carbide parts to form a sintered ceramic joint.

9. The method of claim 8, wherein the one or more ceramics comprises silicon carbide, metal oxides and raw mineral materials.

10. The method of claim 8, further comprising the step of depositing a layer of chemical vapor deposited silicon carbide on at least the sintered ceramic joint.
